# EUROPEAN PATENT APPLICATION

(11) **EP 4 712 143 A1**
(43) Date of publication of application: **18.03.2026**
(21) Application number: 24807429.6
(22) Date of filing: 08.05.2024
(51) Int. Cl.: H01L 33/22, H01L 33/12, H01L 33/48, H01L 33/60, F21K 9/66, F21K 9/238

(54) **LIGHT EMITTING DEVICE AND LIGHT EMITTING MODULE AND DEVICE INCLUDING SAME**

(30) Priority: 12.05.2023 US 202363465928 P; 06.05.2024 US 202418655796
(71) Applicant: Seoul Viosys Co., Ltd., Ansan-si, Gyeonggi-do 15429 (KR)
(72) Inventor: YANG, In Bum, Ansan-si, Gyeonggi-do 15429 (KR)
(74) Representative: Stolmár & Partner Patentanwälte PartG mbB
(86) International application number: PCT/KR2024/006177
(87) International publication number: WO 2024/237553

(57) **Abstract**

This document is about a light emitting device having a protrusion pattern structure.

A light emitting device to be proposed includes: a substrate including a first protrusion pattern on its top surface; a base layer formed on a top of the substrate; a first electrode layer formed on a top of the base layer; a light emitting layer formed on a top of the first electrode layer; and a second electrode layer formed on a top of the light emitting layer, wherein the base layer includes a second protrusion pattern different from the first protrusion pattern on a top surface thereof.

## Description

### [Technical Field]

The following description is about a light emitting device having a protrusion pattern structure, and specifically about a light emitting device that improves light extraction efficiency through a plurality of protrusion pattern structures, and increases an efficiency of an EPI process, and a method of manufacturing the same.

### [Background Art]

A light emitting diode is an inorganic semiconductor device that emits light generated through the recombination of electrons and holes, and has recently been used in various technical fields such as display apparatuses, automobile lamps, and general lighting. The light emitting diode has a long lifespan, low power consumption, and high response speed, and thus, a light emitting device including the light emitting diode is expected to replace a conventional light source.

However, in the process of emitting light generated from the light emitting diode to the outside, light is trapped inside the light emitting diode and is not emitted to the outside, and thus, there is a drawback that light emission efficiency decreases.

### [Disclosure]

### [Technical Problem]

To solve the drawback described above, one aspect of the present disclosure proposes a light emitting device that improves light extraction efficiency through a plurality of protrusion pattern structures.

As a specific example, it is proposed to form a second protrusion pattern, which is different from a first protrusion pattern formed on a top surface of a substrate, on a top of a base layer, to improve light extraction efficiency through diversifying a pattern of light reflected by the first protrusion pattern.

In addition, light extraction efficiency and efficiency of an epitaxial process are provided by making the second protrusion pattern have a lower height and a smaller pitch than those of the first protrusion pattern, but have a higher fill factor

Moreover, light extraction efficiency is intended to be improved based on a change in refractive index on a light path by configuring materials of the protrusion patterns in consideration of a relationship between refractive indices.

The problems to be solved by the present disclosure are not limited to the technical problems mentioned above, and other technical problems not mentioned will be clearly understood from the description below by those of ordinary skill in the art to which the present disclosure belongs.

### [Technical Solution]

In one aspect of the present disclosure for solving the problems described above, there is provided a light emitting device; the light emitting device, including: a substrate including a first protrusion pattern on its top surface; a base layer formed on a top of the substrate; a first electrode layer formed on a top of the base layer; a light emitting layer formed on a top of the first electrode layer; and a second electrode layer formed on a top of the light emitting layer, in which the base layer includes a second protrusion pattern different from the first protrusion pattern on its top surface.

The first protrusion pattern and the second protrusion pattern may have a repeating protrusion pattern, respectively, and in this case, it is preferable that a unit feature of the second protrusion pattern is different in size from that of the first protrusion pattern.

Specifically, it is preferable that a cross-sectional height of the second protrusion pattern is formed to be lower than that of the first protrusion pattern.

Herein, a unit protrusion feature of the second protrusion pattern has a shape including one or more of a cone shape, a hemispherical shape, a cone shape with a gentle inclination toward a top thereof, a top truncated cone shape, and a top truncated cone shape with irregularities formed on a top thereof.

Considering these various cone shapes, it is preferable that a pitch between the unit protrusion features of the second protrusion pattern is smaller than a pitch between unit protrusion features of the first protrusion pattern.

In addition, the top surface of the base layer may include a first region where the second protrusion pattern is formed and a second region where the second protrusion pattern is not formed.

In an embodiment in which the first/second protrusion patterns have the cone shape, it is preferable that the cone shape of the second protrusion pattern is formed to have different left and right inclination angles, and a difference between the left and right inclination angles is formed to be within 5% of a larger inclination angle among the left inclination angle and the right inclination angle.

In addition, between the top of the base layer on which the second protrusion pattern is formed and the first electrode layer, an epitaxial layer made of a material having one or more elements in common with that of the base layer, may be further included, and it is preferably that the second protrusion pattern is made of a material having a fourth refractive index that is lower than a first refractive index of the base layer and a second refractive index of the epitaxial layer, but higher than a third refractive index, which is a refractive index of air.

In this case, between a bottom of the epitaxial layer and the top of the second protrusion pattern, a buffer layer formed along the second protrusion pattern may be further included.

The buffer layer may be formed on both the first region where the second protrusion pattern is formed and the second region where the second protrusion pattern is not formed, on the top of the base layer.

It is preferable that the buffer layer is formed of a material having a refractive index in a range between the fourth refractive index and the second refractive index.

The second protrusion pattern according to an embodiment of the present disclosure may be made of a material having a first refractive index up to a first height, and a material having a second refractive index above the first height, based on a plane forming an interface with the base layer.

The second protrusion pattern may include protrusion features having different shapes from one another between the unit protrusion features.

The first electrode layer, the light emitting layer, and the second electrode layer may be formed on a top of the light emitting device.

In another aspect of the present disclosure for solving the problems described above, there is provided a light emitting module, comprising: a circuit board including a conductive material for electrical connection; and a package bonded to the circuit board through the conductive material, the package, including: one or more lead members; a housing including a cavity; and a light emitting device disposed in the cavity and electrically connected to the lead members, in which the light emitting device includes: a substrate including a first protrusion pattern on its top surface; a first nitride-based epitaxial layer formed on a top of the substrate; a second nitride-based epitaxial layer formed on a top of the first nitride-based epitaxial layer; a first electrode layer formed on a top of the second nitride-based epitaxial layer; a light emitting layer formed on a top of the first electrode layer; and a second electrode layer formed on a top of the light emitting layer, in which a second protrusion pattern made of a material different from that of the first protrusion pattern is included between the first nitride-based epitaxial layer and the second nitride-based epitaxial layer.

For example, a same sapphire material as that of the substrate may be used for the first protrusion pattern, and silicon oxide may be used for the second protrusion pattern. The housing may be formed of a light-reflective material, and thus, may be configured to have a first slope on a side surface such that light generated from the light emitting device is reflected upward to be released to the outside.

It is preferable that the first slope of the housing is different from one or more second slopes formed on a side surface of the first protrusion pattern or the second protrusion pattern.

In this case, the second slope is a concept that includes a third slope formed on the side surface of the second protrusion pattern, and a fourth slope formed on a side surface of the first protrusion pattern, and the third slope may be formed to be smaller than the fourth slope.

In addition, in another aspect of the present disclosure for solving the problems described above, there is provided a light emitting apparatus, comprising: a circuit board including a conductive material for electrical connection; a light emitting device electrically connected to the circuit board; a control device that controls driving of the light emitting device; and a cover disposed over the light emitting device, and transmitting light generated from the light emitting device, in which the light emitting device includes: a substrate including a first protrusion pattern on its top surface; a first nitride-based epitaxial layer formed on a top of the substrate; a second nitride-based epitaxial layer formed on a top of the first nitride-based epitaxial layer; a first electrode layer formed on a top of the second nitride-based epitaxial layer; a light emitting layer formed on a top of the first electrode layer; a second electrode layer formed on a top of the light emitting layer; and, a second protrusion pattern disposed between the first nitride-based epitaxial layer and the second nitride-based epitaxial layer connected to the first nitride-based epitaxial layer in a manner different from a first connection method of the first protrusion pattern and the substrate.

For example, the first protrusion pattern may be made of a same material as that of the substrate by being connected to the substrate in an extended form, and the second protrusion pattern may be formed of a material different from that of the first nitride-based epitaxial layer by being embedded in the epitaxial layer.

On a top perspective view of the light emitting device, the light emitting device may be configured to include an overlapping region where the first protrusion pattern and the second protrusion pattern overlap, and a non-overlapping region where the first protrusion pattern and the second protrusion pattern do not overlap.

In addition, on the top perspective view of the light emitting device, the light emitting device may be configured such that center points of unit features of the first protrusion pattern and center points of unit features of the second protrusion pattern are arranged at a predetermined ratio or less.

### [Advantageous Effects]

According to embodiments of the present disclosure as described above, a light emitting device with improved light extraction efficiency may be implemented through a plurality of protrusion pattern structures.

Specifically, a second protrusion pattern, which is different from a first protrusion pattern formed on a top surface of a substrate, is formed on a top of a base layer, and thus, light extraction efficiency may be improved through diversifying a pattern of light reflected by the first protrusion pattern.

In addition, light extraction efficiency and efficiency of an epitaxial process may be provided by making the second protrusion pattern have a lower height and a smaller pitch than those of the first protrusion pattern, but have a higher fill factor.

In addition, light extraction efficiency may be improved based on a change in refractive index on a light path by configuring materials of the protrusion patterns in consideration of a relationship between refractive indices.

Effects that can be obtained from the present disclosure are not limited to the effects mentioned above, and other effects not mentioned will be clearly understood from the description below by those of ordinary skill in the art to which the present disclosure belongs.

### [Description of Drawings]

FIG. 1 is a diagram illustrating a structure of a light emitting device including a protrusion pattern according to an embodiment of the present disclosure.
FIG. 2 is a diagram illustrating a shape of a second protrusion pattern according to various embodiments of the present disclosure.
FIGs. 3 and 4 are diagrams illustrating a cone shape of a second protrusion pattern according to an embodiment of the present disclosure.
FIG.5 is a diagram illustrating a configuration of a second protrusion pattern according to various embodiments of the present disclosure.
FIG. 6 is a diagram illustrating a structure of a light emitting device that further includes a buffer layer according to an embodiment of the present disclosure.
FIGs. 7 and 8 are diagrams illustrating a structure of a protrusion pattern according to other embodiments of the present disclosure.
FIG. 9 is a diagram illustrating a structure in which a light emitting device according to an embodiment of the present disclosure is applied to a light emitting apparatus.
FIG. 10 is a diagram illustrating processes of separate growth of a light emitting device according to one aspect of the present disclosure.
FIG. 11 is a diagram illustrating a package and module to which embodiments of the present disclosure are applied.
FIG. 12 is a diagram illustrating a lighting apparatus according to an embodiment of the present disclosure.
FIG. 13 is a cross-sectional view illustrating a display apparatus to which a light emitting device according to another embodiment of the present disclosure is applied.
FIG. 14 is a cross-sectional view illustrating an example of applying a light emitting device according to another embodiment of the present disclosure to a headlamp.
FIG. 15 is a cross-sectional view illustrating an example of applying a light emitting device according to another embodiment of the present disclosure to a display panel.
FIG. 16 is a diagram illustrating examples of a smart watch, a VR headset, and augmented reality glasses according to other embodiments of the present disclosure.

### [Detailed Description of the Illustrated Embodiments]

Hereinafter, embodiments of the present disclosure will be described in detail with reference to the accompanying drawings such that those of ordinary skill in the art to which the present disclosure belongs can easily implement it. However, the present disclosure may be implemented in many different forms and is not limited to the embodiments described herein. In order to clearly explain the present disclosure in the drawings, parts that are not related to the description are omitted, and similar parts are given similar reference numerals throughout the specification.

Throughout the specification, when a portion "includes" a certain element, this means that it may further include other elements rather than excluding other elements, unless specifically stated to the contrary.

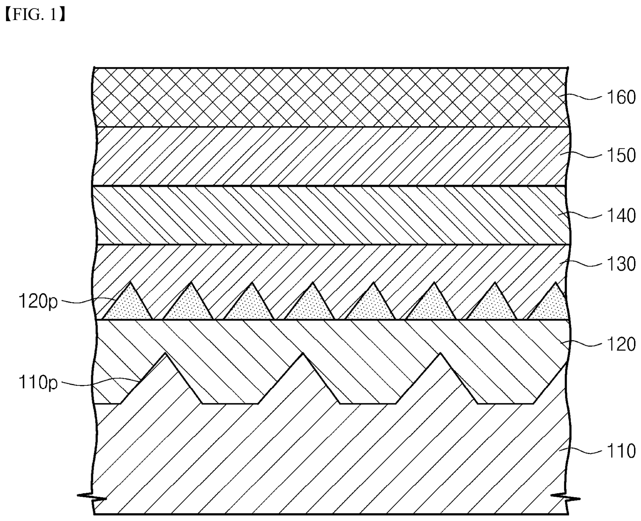

FIG. 1 is a diagram illustrating a structure of a light emitting device including a protrusion pattern according to an embodiment of the present disclosure.

The light emitting device shown in FIG. 1 is characterized in that it includes a substrate 110 including a first protrusion pattern 110p on its top surface, a base layer 120 formed on a top of the substrate 110, and the base layer 120 includes a second protrusion pattern 120p, which is different from the first protrusion pattern 110p on a top surface thereof.

As for the substrate 110, a light-transmissive substrate may be used, and in addition to a sapphire substrate, a silicon substrate, a silicon carbide substrate, and a graphene substrate, other materials capable of high temperature stability may be used, or may be used in a form with added impurities.

As shown in FIG. 1, the substrate 110 may have a first protrusion pattern 110p formed on a top thereof, which may be seen as a structure to solve a drawback of difficulty in epitaxial layer growth due to a difference in lattice mismatch between the substrate 110 and a nitride-based epitaxial layer on the top of the substrate.

That is, the substrate 110 having the first protrusion pattern 110p has a micro-sized pattern of a certain shape on its surface. When a nitride layer is epitaxially grown on a patterned substrate 110, it is possible to increase light efficiency by reducing crystal defects (reduction due to bending of defects during growth) and total internal reflection compared to growing the nitride layer on a plane.

However, when light is scattered by the first protrusion pattern 110p as described above, some of light wanders around inside and is trapped, due to a certain pattern of the first protrusion pattern 110p, and thus, efforts are needed to improve the extraction of light that could not be emitted. To minimize this light trap phenomenon, it is proposed in this embodiment that the second protrusion pattern 120p is formed on a top of the base layer 120, and the second protrusion pattern 120p has a different structure, and/or pattern from that of the first protrusion pattern 110p. The second protrusion pattern 120p may be disposed to be embedded between semiconductor layers disposed over and under the second protrusion pattern 120p, and in addition, a plurality of second protrusion patterns 120p may be formed and independently spaced apart from one another. A detailed description regarding the second protrusion pattern 120p will be provided below.

Meanwhile, the light emitting device according to this embodiment, after an epitaxial layer 130 is formed on the top of the base layer 120 described above, may further include a first electrode layer 140, a light emitting layer 150 formed on a top of the first electrode layer 140, and a second electrode layer 160 formed on a top of the light emitting layer 150.

In the above description, the base layer 120 can be seen as a name to emphasize a meaning of being a basis for a growth of the epitaxial layer 130, and when the base layer is also formed by nitride-based epitaxial growth, it may be referred to as a first nitride-based epitaxial layer 120, and an epitaxial layer formed on a top of the second protrusion pattern 120p as a second nitride-based epitaxial layer 130.

The first electrode layer 140 may be made of an n-electrode layer, and the second electrode layer 160 may be made of a p-electrode layer.

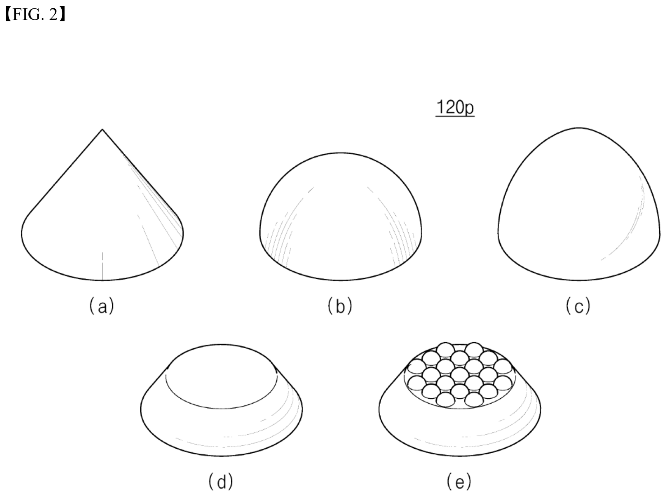

FIG. 2 is a diagram illustrating a shape of a second protrusion pattern according to various embodiments of the present disclosure.

A unit protrusion feature of the second protrusion pattern 120p described above in FIG. 1 may include, as shown in FIG. 2, one or more of a cone shape (FIG. 2(a)), a hemispherical shape (FIG. 2(b)), a cone shape in which an inclination angle of an inclined portion gradually decreases toward a top thereof, (FIG. 2c)), a top truncated cone shape (FIG. 2(d)), and a top truncated cone shape with irregularities formed on a top thereof (FIG. 2(e)).

Since the second protrusion pattern 120p serves to form a pattern of a different shape from that of the first protrusion pattern 110p, even when a unit protrusion feature of the first protrusion pattern 110p is a cone shape ((a) or c)), the second protrusion pattern 120p is not limited thereto, and for randomization of a light path, and depending on characteristics of a process for forming the second protrusion pattern 120p, a variety of unit protrusion features as shown in FIG. 2 may be used.

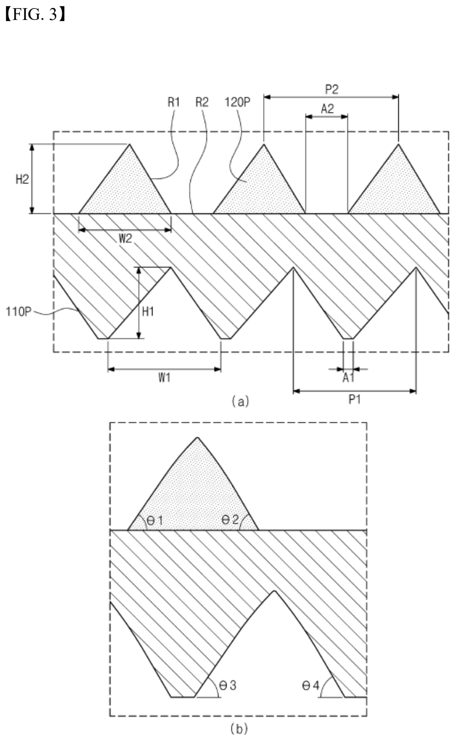

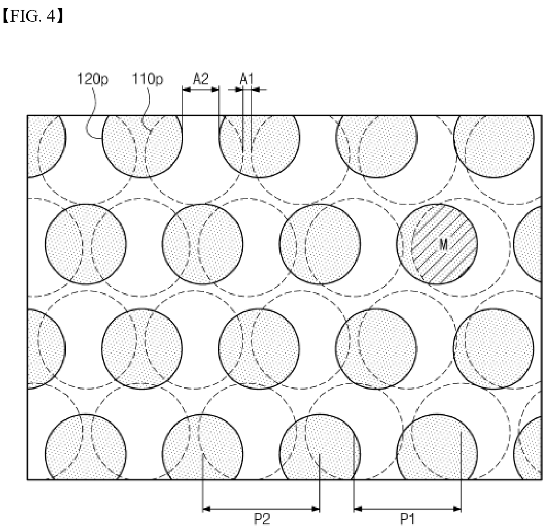

FIGs. 3 and 4 are diagrams illustrating a cone shape of a second protrusion pattern according to an embodiment of the present disclosure.

In the embodiment illustrated in FIG. 3, it is assumed that both a first protrusion pattern 110p and a second protrusion pattern 120p have a cone-shaped repeating protrusion pattern, respectively.

In this case, a cone shape of the second protrusion pattern 120p is different in size from that of the first protrusion pattern 110p, and specifically, as shown in (a) of FIG. 3, it is preferable that the cone shape of the second protrusion pattern 120p is smaller in width (W2 < W1), and/or lower in height (H2 < H1) than the cone shape of the first protrusion pattern 110p.

Alternatively, W2/W1 may be less than 1, or H2/H1 may be less than 1. Accordingly, a number of the second protrusion patterns 120p arranged per unit area may be formed to be greater than that of the first protrusion patterns 110p. Alternatively, a density of the second protrusion pattern 120p per unit area may be set to be higher than that of the first protrusion pattern 110p.

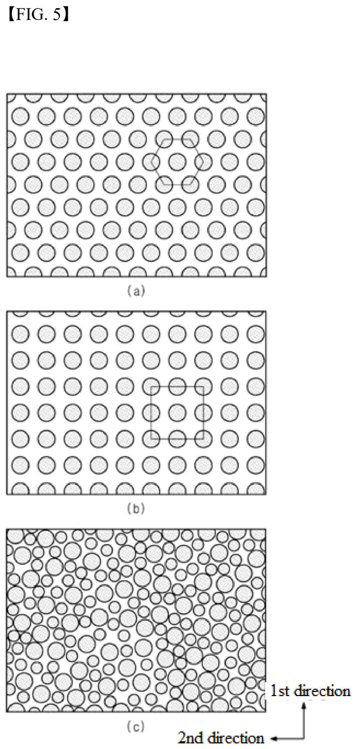

In this way, a fill factor may be increased by forming the second protrusion pattern 120p smaller than the first protrusion pattern 110p. In this document, the fill factor may be defined in various ways, such as a ratio of protrusion patterns included per hexagonal unit as shown in (a) of FIG. 5, which will be described later, or a ratio of protrusion patterns included per quadrangle unit as shown in (b) of FIG. 5, and a high fill factor may play a role in increasing light extraction efficiency. Moreover, by reducing the height of the second protrusion pattern 120p, merge defects may be reduced, and thus, package characteristics may be expected to be improved. Based on a range of the hexagonal unit of the first protrusion pattern 110p, the number of the second protrusion patterns 120p included in the unit may be greater than that of the first protrusion pattern 110p, and accordingly, the fill factor of the second protrusion pattern 120p may be higher than that of the first protrusion pattern 110p.

Meanwhile, as shown in (a) of FIG. 3, a top of a base layer 120 may include a first region R1 where the second protrusion pattern 120p is formed and a second region R2 where the second protrusion pattern 120p is not formed. When a nitride-based epitaxial layer 130 is grown on the top of the base layer 120, in a case that the second protrusion pattern 120p is made of a material selected in consideration of refractive index characteristics as described later, it is preferable that the second region R2 is configured on the top of the base layer 120 to increase an efficiency of growing the nitride-based epitaxial layer 130, and in a preferred embodiment of the present disclosure, as described above, it is proposed that the size of the second protrusion pattern 120p is formed to be smaller than that of the first protrusion pattern 110p, and an area of the second region R2 is secured between the second d protrusion patterns 120p, to increase the efficiency of growing the epitaxial layer 130 on the top thereof. In this case, the base layer 120 may be made of a material including at least one or more of same elements as those of the epitaxial layer 130.

In (a) of FIG. 3, the size of the second protrusion pattern 120p is described based on the width W when compared to that of the first protrusion pattern 110p, but in terms of the above-mentioned fill factor, to form a high fill factor of the second protrusion pattern 120p, it is proposed that a pitch P2 between vertices of the cones of the second protrusion pattern 120p is smaller than a pitch P1 between vertices of the cones of the first protrusion pattern 110p. However, it is proposed that a fill factor of the cone shape of the second protrusion pattern 120p is formed to be larger than that of the cone-shape of the first protrusion pattern 110p.

Referring to (a) of FIG. 3, a minimum separation distance A2 between at least two second protrusion patterns 120p may be greater than a minimum separation distance A1 between at least two first protrusion patterns 110p. The minimum separation distance A2 between the second protrusion patterns 120p may be set to be relatively large to facilitate a growth of a semiconductor layer formed thereover.

Meanwhile, as shown in more detail in enlarged (b) of FIG. 3, the cone shape of the second protrusion pattern 120p may have a different left inclination angle Θ1 and a right inclination angle Θ2. In (b) of FIG. 3, it is exemplarily illustrated that the right inclination angle Θ2 is formed larger than the left inclination angle Θ1, but this may vary depending on an angle at which the cone shape is viewed.

As the left/right (both sides) inclination angles differ, randomness may be further increased in the light path, and as the left/right (both sides) inclination angles differ, a curvature of a surface changes, so a critical angle of refraction on the surface varies and a range thereof becomes wider, and thus, a refraction effect for light incident on the surface at various angles may increase.

However, in a preferred embodiment of the present disclosure, a difference between the left inclination angle Θ1 and the right inclination angle Θ2 may be formed within 5% of a larger inclination angle between the left inclination angle Θ1 and the right inclination angle Θ2 (in a case of (b) of FIG. 3, the right inclination angle Θ2). When the difference in inclination angle is too large, light may be biased in a specific direction, and thus, a bias of light may be prevented by keeping the difference in inclination on both sides within 5%.

In another embodiment, the cone shape of the first protrusion pattern 110p may have a different left inclination angle Θ3 and a right inclination angle Θ4, and at least one of the left inclination angle Θ1 and the right inclination angle Θ2 of the second protrusion pattern 120p may have an angle smaller than at least one of the left inclination angle Θ3 and the right inclination angle Θ4 of the first protrusion pattern 110p. That is, it may be Θ1/Θ2 < Θ3/Θ4. Accordingly, since the side inclination angle of the second protrusion pattern 120p is lower than that of the first protrusion pattern 110p, it becomes easy to form a semiconductor layer over the second protrusion pattern 120p.

In another embodiment, the left inclination angle Θ1, the right inclination angle Θ2 of the second protrusion pattern 120p, the left inclination angle Θ3, and right inclination angle Θ4 of the first protrusion pattern 110p may have different angles from one another. Accordingly, light scattering and light extraction by different angles may be improved.

Referring to FIG. 4, FIG. 4 shows the second protrusion pattern 120p as a solid line, and the first protrusion pattern 110p as a dotted line in plan view. As shown in FIG. 4, a portion of the second protrusion pattern 120p overlaps with a portion of the first protrusion pattern 110p to form an overlap region M, and a portion of the second protrusion pattern 120p may include a region that does not overlap with a portion of the protrusion pattern 110p. It is preferable that the vertices of the second protrusion pattern 120p are spaced apart from the vertices of the first protrusion pattern 110p such that they are not vertically aligned. Accordingly, various light paths may be formed between the first protrusion pattern 110p and the second protrusion pattern 120p.

However, in a process of forming the first protrusion pattern 110p and the second protrusion pattern 120p, there may be unit features in which center points coincidentally coincide among the repeating patterns in a top perspective view, and as such, in an embodiment of the present disclosure, it is proposed to set a proportion of coincidental center points to be less than a certain range (for example, within 5%).

FIG.5 is a diagram illustrating a configuration of a second protrusion pattern according to various embodiments of the present disclosure.

First, (a) of FIG. 5 shows an arrangement in which six second protrusion patterns 120p surround one second protrusion pattern 120p in an arrangement of a plurality of second protrusion patterns 120p. In this case, an arrangement form of the second protrusion pattern 120p may be same as that of a first protrusion pattern 110p. Alternatively, a size of a hexagon connecting centers of the six second protrusion patterns 120p surrounding one second protrusion pattern 120p may be different from a size of a hexagon connecting centers of six first protrusion patterns 110p surrounding one first protrusion pattern 110p.

(b) of FIG. 5 shows an arrangement of a plurality of second protrusion patterns 120p, where a plurality of second protrusion patterns 120p is arranged in a first direction, and a plurality of second protrusion patterns 120p is arranged in a second direction perpendicular to the first direction to have m columns and n rows. Additionally, in the arrangement of the plurality of second protrusion patterns 120p, eight second protrusion patterns 120p may be disposed to surround one second protrusion pattern 120p. Alternatively, a size of a polygon connecting centers of the eight second protrusion patterns 120p surrounding one second protrusion pattern 120p may be different from a shape or a size of a polygon connecting the centers of the six first protrusion patterns 110p surrounding one first protrusion pattern 110p. Accordingly, it may be configured to maximize light extraction efficiency in relation to the first protrusion pattern 110p.

Meanwhile, (c) of FIG. 5 shows a random pattern structure in which a unit protrusion feature of the second protrusion pattern 120p is randomly mixed with large protrusion units and small protrusion units. Heights of the large protrusion unit and the small protrusion unit may be different from each other, and levels at which vertices thereof are positioned may be different. Alternatively, the large protrusion unit and the small protrusion unit may have different maximum widths from each other. This random pattern structure may increase a fill factor per unit area, and light extraction efficiency may be expected to increase accordingly.

As described above, it is preferable that the second protrusion pattern 120p is made of a material having a fourth refractive index (n₄) that is lower than a first refractive index (n₁) of the base layer 120p and a second refractive index (n₂) of the epitaxial layer 130, but higher than a third refractive index (n₃), which is a refractive index of air. In a case of having a refractive index relationship as described above, light incident on the second protrusion pattern 120p passes through a medium having a 'high-low-high' refractive index in the refractive index relationship, and in this process, randomness of the light path may be increased, thereby reducing a rate at which light is trapped on a bottom of the epitaxial layer 130. However, when a difference between the first refractive index (n₁) or the second refractive index (n₂) and the fourth refractive index (n₄) is greater than a predetermined threshold, a total reflection ratio at a corresponding interface increases, and in this embodiment, it is proposed to use a material with a higher refractive index than that of air as for the fourth refractive index (n₄).

In an embodiment of the present disclosure, as a material that satisfies this refractive index relationship, silicon oxide (SiO₂) or titanium oxide (TiO₂) is proposed to use, without being limited thereto, and various materials may be used as long as they satisfy the refractive index relationship described above.

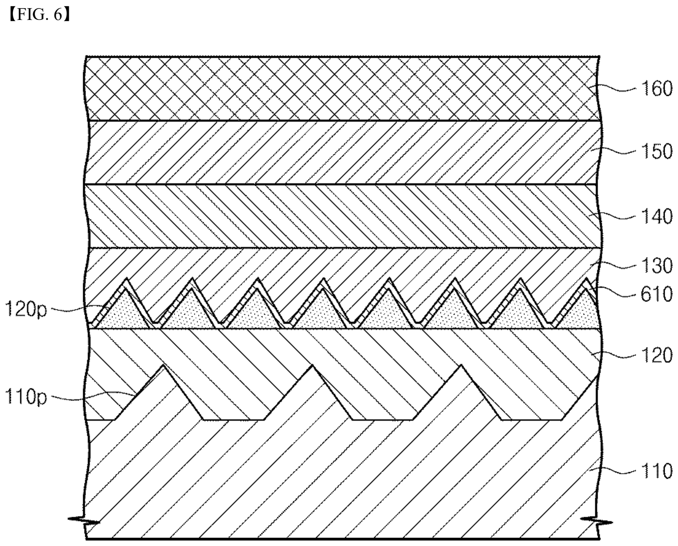

FIG. 6 is a diagram illustrating a structure of a light emitting device that further includes a buffer layer 610 according to an embodiment of the present disclosure.

The light emitting device according to the embodiment shown in FIG. 6 may further include the buffer layer 610 disposed between a bottom of an epitaxial layer 130 and a top of a second protrusion pattern 120p, and the buffer layer 610 may be formed along a surface of the second protrusion pattern 120p.

As shown in FIG. 6, it is preferable that the buffer layer 610 is formed on a top of a base layer 120 to extend from a first region (R1) where the second protrusion pattern 120p is formed to a second region (R2) where the second protrusion pattern 120p is not formed.

In addition, it is preferable that the buffer layer 610 is formed of a material having a refractive index in a range of a fourth refractive index (n₄), which is a refractive index of the second protrusion pattern 120p, and a second refractive index (n₂), which is a refractive index of the epitaxial layer 130. The refractive index of the buffer layer 610 may be greater than 1.4 and less than 2.5.

This buffer layer 610 not only may play a role in facilitating a growth of a nitride-based epitaxial layer 130 on the top of the second protrusion pattern 120p, but also, in relation to the refractive index, may mitigate a degree of refraction caused by a sudden change in the refractive index as light incident on the second protrusion pattern 120p passes through the buffer layer 610 before entering the epitaxial layer 130.

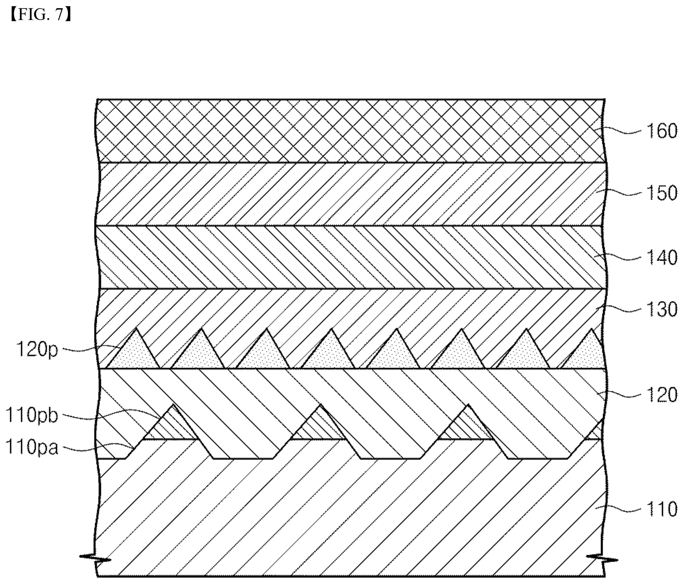

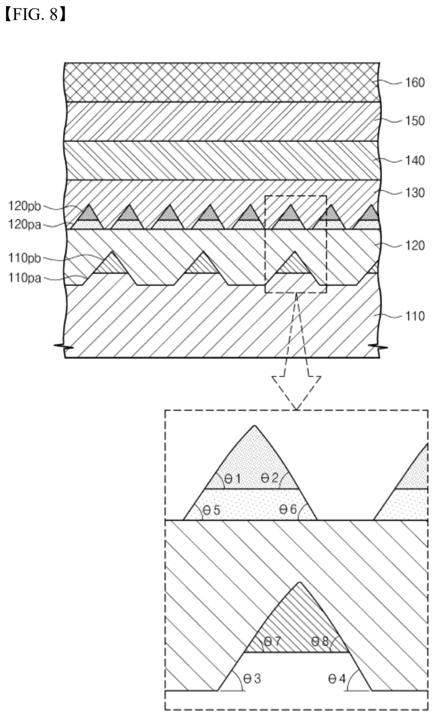

FIGs. 7 and 8 are diagrams illustrating a structure of a protrusion pattern according to other embodiments of the present disclosure.

First, as shown in FIG. 7, a first protrusion pattern 110p, based on a planar height of a portion on a top of a substrate 110 where the first protrusion pattern 110p is not formed, may be configured to include a first portion110pa made of a same material as that of the substrate and extending upward, and a second portion 110pb extending from a top of the first portion 110pa to extend toward a second protrusion pattern 120p and made of a different material from that of the first portion 110pa.

The reason for this is that, using different materials in a process of forming the first protrusion pattern 110p rather than forming the first protrusion pattern 110p with a same material up to an uppermost top thereof may improve light extraction efficiency because a refractive index relationship of each material can be used. A refractive index of the second portion 110pb may be same as that of the second protrusion pattern 120p. Alternatively, the material of the second portion 110pb may be same as that of the second protrusion pattern 120p. A cross-sectional size of the second portion 110pb of the first protrusion pattern 110p may be different from that of the second protrusion pattern 120p. Accordingly, even when the refractive index or material is the same, the sizes of the first protrusion pattern 110p and the second protrusion pattern 120p may be formed differently, and thus, a path length of light passing through the materials may be varied and light extraction efficiency may be improved.

In a case of FIG. 8, the second protrusion pattern 120p is illustrated as being formed divided into two portions 120pa and 120pb, similar to the first protrusion pattern 110p in FIG. 7. That is, the second protrusion pattern 120p is exemplarily illustrated that it is made of a material 120pa having a first refractive index (n_{4_1}) up to a first height based on a plane forming an interface with a base layer 120, and is made of a material 120pb having a second refractive index (n_{4_2}) above the first height.

In FIG. 8, a first portion 120pa of the second protrusion pattern 120p is illustrated as being made of a different material from that of the base layer 120, but the first portion 120pa of the second protrusion pattern 120p may have a shape in which a portion of the base layer 120 extends in a direction of a second portion 120pb.

In cross-sectional view, the first portion 120pa of the second protrusion pattern 120p may include a left inclination angle Θ5 and a right inclination angle Θ6, and the left inclination angle Θ5 and the right inclination angle Θ6 may have different angles from each other. Alternatively, the left inclination angle Θ5 may be greater than a left inclination angle Θ1 of the second portion 120pb of the second protrusion pattern 120p disposed thereover. Alternatively, the right inclination angle Θ6 may be greater than a right inclination angle Θ2 of the second portion 120pb of the second protrusion pattern 120p disposed thereover. Alternatively, a sum of the left inclination angle Θ5 and the right inclination angle Θ6 of the first portion 120pa of the second protrusion pattern 120p may be greater than a sum of the left inclination angle Θ1 and the right inclination angle Θ2 of the second portion 120pb of the second protrusion pattern 120p. That is, it may have a relationship of Θ5+Θ6> Θ1+Θ2. In cross-sectional view, the second portion 110pb of the first protrusion pattern 110p may include a left inclination angle Θ7 and a right inclination angle Θ8, and may have angles different from the left inclination angle Θ1 and the right inclination angle Θ2 of the second portion 120pb of the second protrusion pattern 120p.

In cross-sectional view, the left inclination angle Θ1 of the second portion 120pb and the left inclination angle Θ5 of the first portion 120pa of the second protrusion pattern 120p, and the left inclination angle Θ3 of the first portion 110pa and the left inclination angle Θ7 of the second portion 120pb of the first protrusion pattern 110p may be different from one another. Alternatively, the right inclination angle Θ2 of the second portion 120pb and the right inclination angle Θ6 of the first portion 120pa of the second protrusion pattern 120p, and the right inclination angle Θ4 of the first portion 110pa and the right inclination angle Θ8 of the second portion 120pb of the first protrusion pattern 110p may be different from one another. Accordingly, light extraction may be improved by making the angles arranged in one direction different from one another.

In addition, the second refractive index (n_{4_2}) of the second portion 120pb of the second protrusion pattern 120p may satisfy a condition range of the fourth refractive index (n₄). Alternatively, the second refractive index (n_{4_2}) of the second portion 120pb of the second protrusion pattern 120p may be equal to the refractive index of the second portion 110pb of the first protrusion pattern 110p.

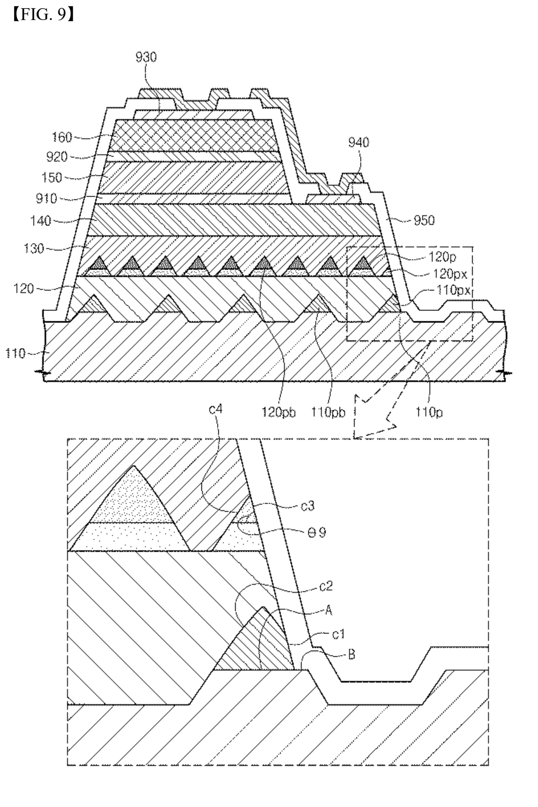

FIG. 9 is a diagram illustrating a structure in which a light emitting device according to an embodiment of the present disclosure is applied to a light emitting apparatus.

The light emitting device shown in FIG. 9, like the light emitting device shown in FIG. 8, includes a substrate 110 including a first protrusion pattern 110p on its top surface, and a base layer 120 formed on a top of the substrate 110. In addition, after an epitaxial layer 130 is formed on a top of the base layer 120, to implement a basic function as a light emitting device, a first electrode layer 140, a light emitting layer 150 formed on a top of the first electrode layer 140, and a second electrode layer 160 formed on a top of the light emitting layer 150 may be further included.

The above-described light emitting layer 150 may use a structure that utilizes a multi-quantum well structure (MQW) in which well layers and barrier layers are alternately stacked as a method to increase a coupling efficiency of electrons and holes in quantum mechanics.

In FIG. 9, in addition to the above description, a superlattice layer 910 may be further formed between the first electrode layer 140 and the light emitting layer 150. Controlling stress through the superlattice layer 910 may reduce crystal defects and create a uniform surface with high quality.

In addition, in FIG. 9, an electron blocking layer (EBL) 920 may be further included between the second electrode layer 160 and the light emitting layer 150. Through this, internal quantum efficiency may be improved. The EBL 920 may improve carrier injection efficiency by preventing electrons from escaping from the light emitting layer 150.

Meanwhile, in the embodiment of FIG. 9, it is illustrated that a first electrode 940 electrically connected to the first electrode layer 140 is configured, a second electrode 930 electrically connected to the second electrode layer 160 is configured, and an insulation layer 950 covering a side surface of the light emitting device is formed.

That is, a second protrusion pattern 120p as shown in FIG. 9 may include a third protrusion shape 120px having a different shape from that of a second portion 110pb of the second protrusion pattern 120p. Alternatively, the second protrusion pattern 120p may include a 2-1 protrusion shape 120px having a size different from that of the second portion 110pb of the second protrusion pattern 120p. The 2-1 protrusion shape 120px may be disposed close to the side surface of the light emitting device to have a side surface inclined along the side surface of the light emitting device. In cross-sectional view, a slope of an outer surface c3 of the 2-1 protrusion shape 120px may be different from that of an inner surface c4 which shares a vertex with the outer surface c3 and disposed on an opposite side. A position of the vertex of the 2-1 protrusion shape 120px may be positioned lower than that of a vertex of the second portion 110pb of an adjacent second protrusion pattern 120p. Lengths of the outer surface c3 and the inner surface c4 of the 2-1 protrusion shape 120px may be different from each other. For example, as shown in FIG. 9, a portion of the second protrusion pattern 120p or the second portion 110pb of the second protrusion pattern 120p may be removed, and in a process thereof, the 2-1 protrusion shape 120px having a shape that a portion has been removed from a shape in a growth step may be included.

The first protrusion pattern 110p may include a 1-1 protrusion shape 110px having a size different from that of a second portion 110pb of the first protrusion pattern 110p. A size of the 1-1 protrusion shape 110px may be smaller than that of the second portion 110pb of an adjacent first protrusion pattern 110p. The 1-1 protrusion shape 110px may be disposed close to the side surface of the light emitting device and have a side inclined along the side surface of the light emitting device. Accordingly, in cross-sectional view, an outer surface of the 1-1 protrusion shape 110px by the insulation layer 950 has a slope of an outer surface c1 of the 1-1 protrusion shape 110px that may be different from a slope of an inner surface c2 which shares a vertex with the outer surface c2 and disposed on an opposite side. The outer surface c1 and the inner surface c2 of the 1-1 protrusion shape 110px may be covered with different materials. For example, the outer surface c1 of the 1-1 protrusion shape 110px may be covered by the insulation layer 950, and the inner surface c2 may be covered by a material with a higher refractive index than that of the insulation layer 950. A position of the vertex of the 1-1 protrusion shape 110px may be positioned lower than that of the vertex of an adjacent first protrusion shape 110p.

The substrate 110 may be formed to overlap with the light emitting device and extend outward from the light emitting device, and a first portion 110pa of the first protrusion shape 110p adjacent to the side surface of the light emitting device may include, in some regions, a first area A where the 1-1 protrusion shape 110px is disposed and a second region B exposed by the second portion 110pb, both of which are made of different materials. The second region B may be covered by the insulation layer 950. An outwardly extended portion of the first protrusion shape 110p may include the first portion 110pa of the first protrusion pattern 110p, and may not include the second portion 110pb. The outer surface c1 of the 1-1 protrusion shape 110px may include a surface with a different inclination. Alternatively, lengths of the outer surface c1 and the inner surface c2 of the 1-1 protrusion shape 110px may be different from each other.

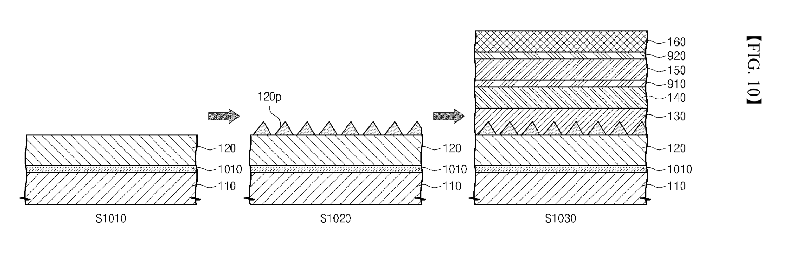

FIG. 10 is a diagram illustrating processes of separate growth of a light emitting device according to one aspect of the present disclosure.

When the above-described structure is used, in an embodiment of the present disclosure, it may be used in separate growth, which is to form as a template through first step growth (S1020) up to a base layer 120 including a substrate 110 and a second protrusion pattern 120p, and to form a first electrode layer 140, a light emitting layer 150, and a second electrode layer 160 on a top of the template formed by the first step growth (S1020) through a second step growth (S1030).

By configuring the first step growth (S1020) as a template growth step, and proceeding with the second step growth (S1030) separately, there may have an advantage of being able to be divided into a growth step that requires high performance and a growth step that emphasizes production efficiency that is not sensitive to performance.

The buffer layer 610 described above with reference to FIG. 6 may be used as a configuration to reduce dislocation in this separate growth step. For this purpose, AlN may be used as a material for the buffer layer 610, without being limited thereto.

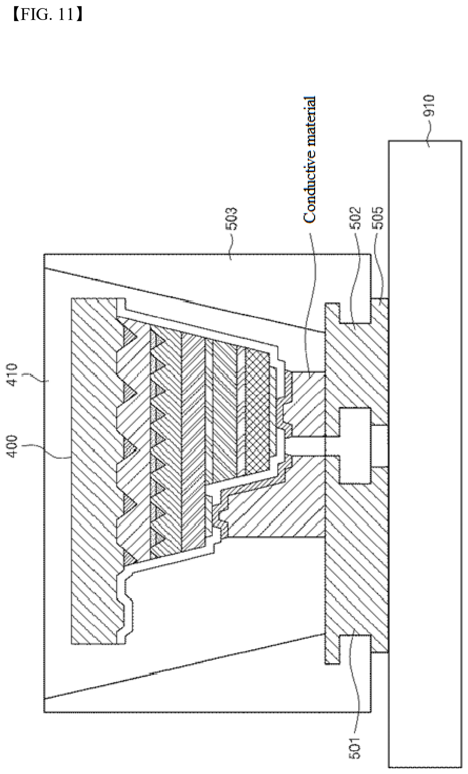

FIG. 11 is a diagram illustrating a package and module to which embodiments of the present disclosure are applied. A lead frame of the package may include a first lead member 501 and a second lead member 502, and the first lead member 501 and the second lead member 502 may be coupled to a housing 503 while being spaced apart from each other. The housing 503 may cover portions of the first lead member 501 and the second lead member 502, and may include a cavity such that a light emitting device 400 can be mounted. The light emitting device 400 may be disposed inside the cavity to be electrically connected to the first lead member 501 and the second lead member 502. The housing 503 may be formed of a light reflective material, and an inner wall of the housing 503 may be formed to be inclined to have a first slope on a side surface such that light generated by the light emitting device 400 and directed to the inner wall is reflected upward and emitted to the outside.

A separated space between the first lead member 501 and the second lead member 502 may be filled with the housing 503, and the first lead member 501 and the second lead member 502 may be maintained spaced apart from each other by the housing 503. A molding 410 may be disposed on an upper surface of the light emitting device 400, and the molding 410 may fill the inside of the cavity of the housing 503. The molding 410 may be formed of a light-transmissive material, and may further include a wavelength conversion material to absorb and convert light generated from the light emitting device 400 to emit light.

Light generated from the light emitting device 400 may pass through a first protrusion shape 110p or a second protrusion shape 120p to be emitted to the outside. That is, the first protrusion shape 110p or the second protrusion shape 120p may be disposed between a light emitting layer 150 and the molding 410 of the light emitting device 400. A second slope of an outer surface of the first protrusion shape 110p or the second protrusion shape 120p (e.g., a slope based on any angle of Θ1 to Θ6 described above) and a first slope of a side reflective surface of the housing 503 may be formed differently to be effective in extracting light to the outside.

The module according to an embodiment of the present disclosure may include a circuit board 910, and the package may be disposed on the circuit board 910 to be bonded to the circuit board 910 with a conductive material 505.

The module may be applied to vehicle lamps, display modules, lighting apparatuses, and the like.

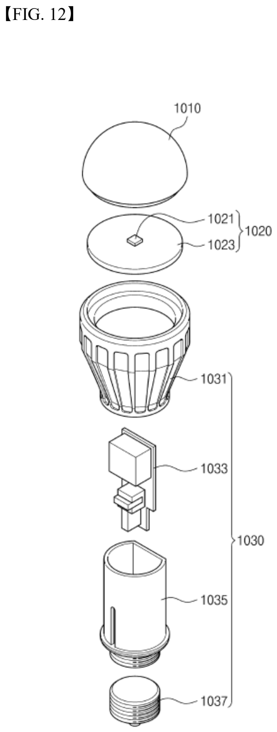

FIG. 12 is a diagram illustrating a lighting apparatus according to an embodiment of the present disclosure.

Referring to FIG. 12, the lighting apparatus according to this embodiment includes a diffusion cover 1010, a light emitting device module 1020, and a body portion 1030. The body portion 1030 may accommodate the light emitting device module 1020, and the diffusion cover 1010 may be disposed on the body portion 1030 to cover an upper portion of the light emitting device module 1020.

The body portion 1030 is not limited as long as it can accommodate and support the light emitting device module 1020 and supply electrical power to the light emitting device module 1020. For example, as shown in the drawings, the body portion 1030 may include a body case 1031, a power supply apparatus 1033, a power case 1035, and a power connection portion 1037.

The power supply apparatus 1033 is accommodated in the power case 1035 and is electrically connected to the light emitting device module 1020, and may include at least one IC chip. The IC chip may adjust, convert, or control characteristics of power supplied to the light emitting device module 1020. The power case 1035 may accommodate and support the power supply apparatus 1033, and the power case 1035 with the power supply apparatus 1033 secured therein may be positioned inside the body case 1031. The power connection portion 1037 may be disposed at a bottom of the power case 1035, and bonded to the power case 1035. Accordingly, the power connection portion 1037 is electrically connected to the power supply apparatus 1033 inside the power case 1035, and may serve as a passage through which external power can be supplied to the power supply apparatus 1033.

The light emitting device module 1020 includes a substrate 1023 and a light emitting device 1021 disposed on the substrate 1023. The light emitting device 1021 may include the first protrusion pattern 110p and the second protrusion pattern 120p as described above in FIG. 1 and the like. The light emitting device module 1020 may be provided in an upper portion of the body case 1031 and electrically connected to the power supply apparatus 1033.

The substrate 1023 is not limited as long as it can support the light emitting device 1021, and may be, for example, a printed circuit board including interconnection lines. The substrate 1023 may have a shape corresponding to a secure portion on the upper portion of the body case 1031 such that it can be stably secured to the body case 1031. The light emitting device 1021 may include at least one of the light emitting devices according to the embodiments of the present disclosure described above.

The diffusion cover 1010 may be disposed on the light emitting device 1021, and may be secured to the body case 1031 to cover the light emitting device 1021. The diffusion cover 1010 may have a light-transmitting material, and viewing characteristics of the lighting apparatus may be adjusted by adjusting a shape and light transmittance of the diffusion cover 1010. Therefore, the diffusion cover 1010 may be modified into various forms depending on a purpose of use and application of the lighting apparatus.

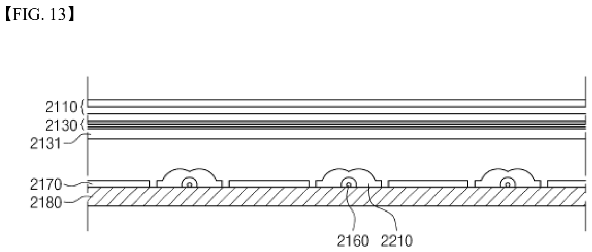

FIG. 13 is a cross-sectional view illustrating a display apparatus to which a light emitting device according to another embodiment of the present disclosure is applied.

The display apparatus of this embodiment includes a display panel 2110, a backlight unit providing light to the display panel 2110, and a panel guide supporting a lower edge of the display panel 2110.

The display panel 2110 is not particularly limited, and may be, for example, a liquid crystal display panel including a liquid crystal layer. A gate driving PCB that supplies a driving signal to a gate line may be further positioned at an edge of the display panel 2110. Herein, the gate driving PCB may not be formed on an additional PCB, but may be formed on a thin film transistor substrate.

The backlight unit includes a light source module including at least one substrate and a plurality of light emitting devices 2160. Furthermore, the backlight unit may further include a bottom cover 2180, a reflection sheet 2170, a diffusion plate 2131, and optical sheets 2130.

The bottom cover 2180 may be opened upward, and accommodate a substrate, the light emitting device 2160, the reflection sheet 2170, the diffusion plate 2131, and the optical sheets 2130. In addition, the bottom cover 2180 may be coupled with a panel guide. A substrate may be positioned under the reflection sheet 2170, and disposed surrounded by the reflection sheet 2170. However, the present disclosure is not limited thereto, and in a case that a reflective material is coated on its surface, it may be positioned on the reflection sheet 2170. In addition, the substrate may be formed in plural, and a plurality of substrates may be arranged in a form flush with one another, but the present disclosure is not limited thereto, and may be formed as a single substrate.

The light emitting device 2160 may include at least one of the light emitting devices according to the embodiments of the present disclosure described above. That is, the light emitting device 2160 may include the first protrusion pattern 110p and the second protrusion pattern 120p as described above in FIG. 1 and the like. The light emitting devices 2160 may be regularly arranged in a certain pattern on the substrate. In addition, a lens 2210 may be disposed on each of the light emitting devices 2160, and improve a uniformity of light emitted from the plurality of light emitting devices 2160.

The diffusion plate 2131 and the optical sheets 2130 are positioned on the light emitting device 2160. Light emitted from the light emitting device 2160 may be supplied to the display panel 2110 in a form of a surface light source through the diffusion plate 2131 and the optical sheets 2130.

As such, the light emitting device according to the embodiments of the present disclosure may be applied to a direct display apparatus such as the present embodiment.

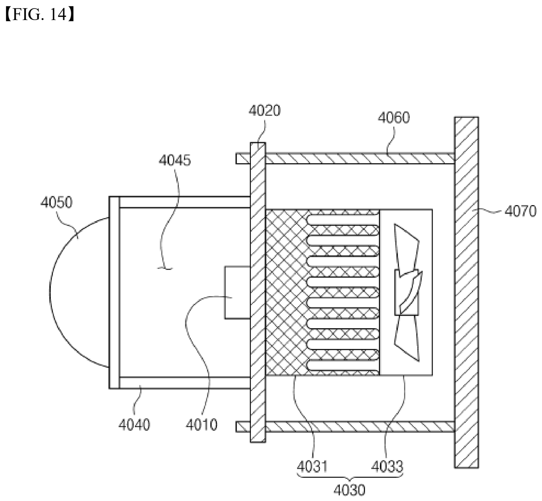

FIG. 14 is a cross-sectional view illustrating an example of applying a light emitting device according to another embodiment of the present disclosure to a headlamp.

Referring to FIG. 14, the headlamp includes a lamp body 4070, a substrate 4020, a light emitting device 4010, and a cover lens 4050. Furthermore, the headlamp may further include a heat dissipation unit 4030, a support rack 4060, and a connection member 4040.

The substrate 4020 is secured by the support rack 4060 and spaced apart from the lamp body 4070. The substrate 4020 is not limited as long as it can support the light emitting device 4010, and may be, for example, a substrate with a conductive pattern such as a printed circuit board. The light emitting device 4010 may be disposed on the substrate 4020, and supported and secured by the substrate 4020. In addition, the light emitting device 4010 may be electrically connected to an external power source through the conductive pattern of the substrate 4020. Moreover, the light emitting device 4010 may include at least one light emitting device according to the embodiments of the present disclosure described above. That is, the light emitting device 4010 may include the first protrusion pattern 110p and the second protrusion pattern 120p as described above in FIG. 1 and the like.

The cover lens 4050 is disposed on a path along which light emitted from the light emitting device 4010 proceeds. For example, as shown in the drawings, the cover lens 4050 may be arranged to be spaced apart from the light emitting device 4010 by the connection member 4040, and may be disposed in a direction in which light emitted from the light emitting device 4010 is to be provided. Viewing angles and/or colors of light emitted from the headlamp to the outside may be adjusted by the cover lens 4050. Meanwhile, the connection member 4040 secures the cover lens 4050 to the substrate 4020, and may also serve as a light guide that is arranged to surround the light emitting device 4010 and provides a light emission path 4045. In this case, the connection member 4040 may be formed of a light-reflective material, or coated with a light-reflective material. Meanwhile, the heat dissipation unit 4030 may include a heat dissipation fin 4031 and/or a heat dissipation fan 4033, and dissipates heat generated upon operation of the light emitting diode 4010.

As such, the light emitting device according to the embodiments of the present disclosure may be applied to the headlamp as that of this embodiment, especially a headlamp for a vehicle.

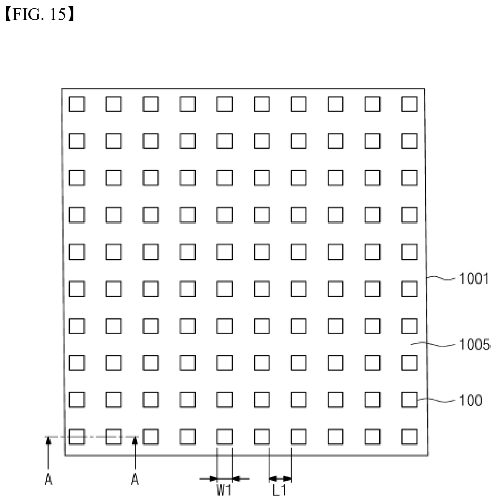

FIG. 15 is a cross-sectional view illustrating an example of applying a light emitting device according to another embodiment of the present disclosure to a display panel.

The display panel includes a circuit board 1001, light emitting devices 100, and a buffer material layer 1005.

The circuit board 1001 or panel board may include circuitry for passive matrix driving or active matrix driving. In an embodiment, the circuit board 1001 may include interconnection lines and resistors therein. In another embodiment, the circuit board 1001 may include interconnection lines, transistors, and capacitors. The circuit board 1001 may also have pads 1003 on its upper surface to allow electrical connection to the circuits disposed therein.

A plurality of light emitting devices 100 is arranged on the circuit board 1001. The light emitting devices 100 may be small light emitting devices having a size in micro units, and a width W1 may be 300 µm or less. In an embodiment, an interval L1 between the light emitting devices 100 in a direction in which the light emitting devices 100 are arranged may be wider than the width W1 of the light emitting devices 100 in that direction. Each of the light emitting devices 100 constitutes one pixel. For example, each of the light emitting devices 100 may include blue, green, and red subpixels. This light emitting device 100 may include the first protrusion pattern 110p and the second protrusion pattern 120p as described above in FIG. 1 and the like.

The buffer material layer 1005 may cover the circuit board 1001 between the light emitting devices 100, and cover upper surfaces of the light emitting devices 100. The buffer material layer 1005 may also include a matrix that is transparent to light, but the present disclosure is not limited thereto. For example, the buffer material layer 1005 may reflect or absorb light, and for this purpose, a matrix with light reflection characteristics or a matrix with light absorption characteristics may be used. Alternatively, a light absorbing material such as carbon black or a light scattering material such as silica may be contained in the matrix.

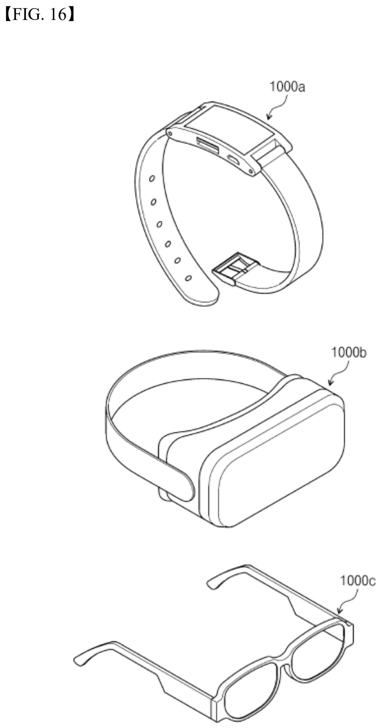

FIG. 16 is a diagram illustrating examples of a smart watch, a VR headset, and augmented reality glasses according to other embodiments of the present disclosure.

Referring to FIG. 16, the light emitting device according to the present disclosure may be used in a VR display apparatus such as a smart watch 1000a or a VR headset 1000b, an AR display apparatus such as augmented reality glasses 1000c, or a display apparatus such as signage.

A detailed description of preferred embodiments of the invention disclosed above is provided to enable any person skilled in the art to implement or practice the invention. Although the present disclosure has been described above with reference to preferred embodiments, those skilled in the art will understand that various modifications and changes can be made to the present disclosure without departing from the scope of the present disclosure. For example, a person skilled in the art may use each configuration described in the above-described embodiments by combining them with each other.

Therefore, the present disclosure is not intended to be limited to the embodiments shown herein, but is to be accorded the widest scope consistent with the principles and novel features disclosed herein.

### [Industrial Applicability]

The light emitting device according to the embodiments of the present disclosure as described above may be applied to various technical fields such as display apparatuses and automobile lamps as well as general lighting apparatuses by increasing light extraction efficiency.

## Claims

1. A light emitting device, comprising;
a substrate including a first protrusion pattern on its top surface;
a base layer formed on a top of the substrate;
a first electrode layer formed on a top of the base layer;
a light emitting layer formed on a top of the first electrode layer; and
a second electrode layer formed on a top of the light emitting layer,
wherein a second protrusion pattern having a refractive index different from that of the first protrusion pattern is disposed between the base layer and the first electrode layer.

2. The light emitting device of claim 1, wherein:
the first protrusion pattern and the second protrusion pattern have a repeating protrusion pattern, respectively, and
a unit feature of the second protrusion pattern is different in size from that of the first protrusion pattern.

3. The light emitting device of claim 1,
wherein a cross-sectional height of the second protrusion pattern is lower than a cross-sectional height of the first protrusion pattern.

4. The light emitting device of claim 1,
wherein a pitch between unit protrusion features of the second protrusion pattern is smaller than a pitch between unit protrusion features of the first protrusion pattern.

5. The light emitting device of claim 1,
wherein a top surface of the base layer comprises a first region where the second protrusion pattern is formed and a second region where the second protrusion pattern is not formed.

6. The light emitting device of claim 1, wherein:
a shape of the second protrusion pattern is formed to have different left and right inclination angles, and
a difference between the left inclination angle and the right inclination angle is formed to be within 5% of a larger inclination angle among the left inclination angle and the right inclination angle.

7. The light emitting device of claim 1, further comprising:
between a top of the second protrusion pattern and the first electrode layer, an epitaxial layer made of a material having one or more elements in common with that of the base layer,
wherein the second protrusion pattern is made of a material having a fourth refractive index that is lower than a first refractive index of the base layer and a second refractive index of the epitaxial layer, but higher than a third refractive index, which is a refractive index of air.

8. The light emitting device of claim 7, further comprising:
between a bottom of the epitaxial layer and the top of the second protrusion pattern, a buffer layer formed along the second protrusion pattern.

9. The light emitting device of claim 8,
wherein the buffer layer is formed on both a first region where the second protrusion pattern is formed and a second region where the second protrusion pattern is not formed, on the top of the base layer.

10. The light emitting device of claim 8,
wherein the buffer layer is formed of a material having a refractive index in a range between the fourth refractive index and the second refractive index.

11. The light emitting device of claim 1,
wherein the second protrusion pattern is made of a material having a first refractive index up to a first height, and a material having a second refractive index above the first height, based on a plane forming an interface with the base layer.

12. The light emitting device of claim 1,
wherein the second protrusion pattern includes protrusion features having different shapes from one another between the unit protrusion features.

13. The light emitting device of claim 1,
wherein the unit protrusion feature of the second protrusion pattern has a shape including one or more of a cone shape, a hemispherical shape, a top truncated cone shape, and a top truncated cone shape with irregularities formed on the top.

14. A light emitting module, comprising:
a circuit board including a conductive material for electrical connections; and
a package bonded to the circuit board through the conductive material,
the package, comprising:
one or more lead members;
a housing including a cavity; and
a light emitting device disposed in the cavity and electrically connected to the lead members,
the light emitting device, comprising:
a substrate including a first protrusion pattern on its top surface;
a first nitride-based epitaxial layer formed on a top of the substrate;
a second nitride-based epitaxial layer formed on a top of the first nitride-based epitaxial layer;
a first electrode layer formed on a top of the second nitride-based epitaxial layer;
a light emitting layer formed on a top of the first electrode layer; and
a second electrode layer formed on a top of the light emitting layer,
wherein a second protrusion pattern made of a material different from that of the first protrusion pattern is included between the first nitride-based epitaxial layer and the second nitride-based epitaxial layer.

15. The light emitting module of claim 14,
wherein the housing is formed of a light-reflective material, and thus, is configured to have a first slope on a side surface such that light generated from the light emitting device is reflected upward to be released to the outside.

16. The light emitting module of claim 15,
wherein the first slope of the housing is different from one or more second slopes formed on a side surface of the first protrusion pattern or the second protrusion pattern.

17. The light emitting module of claim 14, wherein:
the second slope includes a third slope formed on the side surface of the second protrusion pattern and a fourth slope formed on a side surface of the first protrusion pattern, and
the third slope is formed to be smaller than the fourth slope.

18. A light emitting apparatus, comprising:
a circuit board board including a conductive material for electrical connections;
a light emitting device electrically connected to the circuit board;
a control device that controls driving of the light emitting device; and
a cover disposed over the light emitting device, and transmitting light generated from the light emitting device,
the light emitting device, comprising:
a substrate including a first protrusion pattern on its top surface;
a first nitride-based epitaxial layer formed on a top of the substrate;
a second nitride-based epitaxial layer formed on a top of the first nitride-based epitaxial layer;
a first electrode layer formed on a top of the second nitride-based epitaxial layer;
a light emitting layer formed on a top of the first electrode layer;
a second electrode layer formed on a top of the light emitting layer; and
a second protrusion pattern disposed between the first nitride-based epitaxial layer and the second nitride-based epitaxial layer, the second protrusion pattern is connected to the first nitride-based epitaxial layer in a manner different from a first connection method of the first protrusion pattern and the substrate.

19. The light emitting apparatus of claim 18,
wherein, on a top perspective view of the light emitting device, the light emitting device is configured to include an overlapping region where the first protrusion pattern and the second protrusion pattern overlap, and a non-overlapping region where the first protrusion pattern and the second protrusion pattern do not overlap.

20. The light emitting apparatus of claim 19,
wherein, on the top perspective view of the light emitting device, the light emitting device is configured such that center points of unit features of the first protrusion pattern and center points of unit features of the second protrusion pattern are arranged at a predetermined ratio or less.
